# EUROPEAN PATENT APPLICATION

(11) **EP 4 757 530 A1**
(43) Date of publication of application: **10.06.2026**
(21) Application number: 24851373.1
(22) Date of filing: 31.05.2024
(51) Int. Cl.: H10D 30/60, H10P 14/40, H10D 8/01, H10D 30/01, H10D 62/80, H10D 12/00, H10D 8/00, H10D 8/50, H10D 8/60

(54) **SILICON CARBIDE SEMICONDUCTOR DEVICE AND MANUFACTURING METHOD THEREFOR**

(30) Priority: 04.08.2023 JP 2023127979
(71) Applicant: Hitachi, Ltd., Tokyo 100-8280 (JP)
(72) Inventor: NISHIDE, Kumiko, Tokyo 100-8280 (JP); OKINO, Hiroyuki, Tokyo 100-8280 (JP); SHIMA, Akio, Tokyo 100-8280 (JP)
(74) Representative: MERH-IP Matias Erny Reichl Hoffmann Patentanwälte PartG mbB
(86) International application number: PCT/JP2024/020058
(87) International publication number: WO 2025/032939

(57) **Abstract**

A silicon carbide semiconductor device includes a semiconductor substrate SB made of 4H-SiC, a collector region CR formed in the semiconductor substrate SB, a contact layer CL in contact with the collector region CR and including a silicide region SCR and a non-silicide region NSCR, and a collector electrode CE in contact with the contact layer CL. A silicide layer SC having an upper surface and a lower surface is formed in the silicide region SCR, an altered layer AL made of 3C-SiC is interposed between the upper surface of the silicide layer SC and the collector region CR, and the lower surface of the silicide layer SC is in contact with the collector electrode CE.

## Description

### Technical Field

The present disclosure relates to a silicon carbide semiconductor device and a manufacturing method thereof, and particularly relates to an IGBT.

### Background Art

In an insulated gate bipolar transistor (IGBT), a silicide layer is interposed between a collector region and a collector electrode in order to form an ohmic electrode having low resistance with respect to a p-type silicon carbide semiconductor layer.

For example, PTL 1 discloses an ohmic electrode including a silicon alloy layer containing aluminum deposited on a back surface of a p-type silicon carbide epitaxial layer ("collector region" described above) and a titanium alloy layer containing aluminum deposited on the silicon alloy layer.

### Citation List

### Patent Literature

PTL 1: JP 2016-154174 A

### Summary of Invention

### Technical Problem

In PTL 1, an aluminum electrode layer and a titanium electrode layer are sequentially deposited on the back surface side of a p-type silicon carbide epitaxial layer, and then the titanium electrode layer and the aluminum electrode layer are irradiated with a laser beam to form an ohmic electrode. However, according to the study of the inventor of the present application, it has been found that the crystal state between the p-type silicon carbide epitaxial layer, the ohmic electrode (silicide layer), and the collector electrode affects the contact resistance. That is, depending on the crystal state, there is a problem that the ON resistance of the IGBT element increases.

Therefore, it is desired to reduce the ON resistance of a silicon carbide semiconductor device such as an IGBT element.

Other problems and novel features will be apparent from the description of the present specification and the accompanying drawings.

### Solution to Problem

An outline of representative embodiments disclosed in the present application will be briefly described as follows.

A silicon carbide semiconductor device according to an embodiment includes a semiconductor substrate including a first main surface and a second main surface positioned on opposite sides in a film thickness direction of the semiconductor substrate, the semiconductor substrate including 4H-SiC, a semiconductor layer formed in the semiconductor substrate on the second main surface of the semiconductor substrate, a contact layer in contact with the second main surface of the semiconductor substrate and including a silicide region and a non-silicide region, and an electrode in contact with the contact layer and formed on a side opposite to the semiconductor substrate with respect to the contact layer. A silicide layer having an upper surface and a lower surface is formed in the silicide region, an altered layer made of 3C-SiC is interposed between the upper surface of the silicide layer and the semiconductor layer, and the lower surface of the silicide layer is in contact with the electrode.

A manufacturing method of a silicon carbide semiconductor device according to an embodiment includes a process (a) of preparing a semiconductor substrate including 4H-SiC and having a first main surface and a second main surface positioned on opposite sides in a film thickness direction of the semiconductor substrate; a process (b) of forming a metal layer on the second main surface of the semiconductor substrate to be in contact with a semiconductor layer formed in the semiconductor substrate on the second main surface of the semiconductor substrate; a process (c) of selectively irradiating the metal layer with a laser beam to form a contact layer including a silicide region and a non-silicide region, and a process (d) of forming an electrode on the contact layer. Then, in the process (c), a silicide layer including a metal layer is formed in a silicide region where the metal layer is irradiated with a laser beam, the metal layer is left in a non-silicide region where the metal layer is not irradiated with a laser beam, and an altered layer made of 3C-SiC is formed at a boundary between the semiconductor layer and the silicide layer in the silicide region.

### Advantageous Effects of Invention

According to one embodiment, the ON resistance of the silicon carbide semiconductor device can be reduced.

### Brief Description of Drawings

[FIG. 1] FIG. 1 is a cross-sectional view of an IGBT according to an embodiment.
[FIG. 2] FIG. 2 is a cross-sectional view for illustrating an operation (ON state) of the IGBT according to the embodiment.
[FIG. 3] FIG. 3 is a plan view of a contact layer of the IGBT according to the embodiment.
[FIG. 4] FIG. 4 is a view illustrating a relationship between an area ratio of a non-silicide region of a contact layer of an IGBT and an increase amount of an on-state voltage according to the embodiment.
[FIG. 5] FIG. 5 is an image diagram of a band diagram from a collector region to a collector electrode of the IGBT according to the embodiment.
[FIG. 6] FIG. 6 is a cross-sectional view of the IGBT according to the embodiment during a manufacturing process.
[FIG. 7] FIG. 7 is a cross-sectional view of the IGBT during a manufacturing process subsequent to FIG. 6.
[FIG. 8] FIG. 8 is a cross-sectional view of the IGBT during the manufacturing process subsequent to FIG. 7.
[FIG. 9] FIG. 9 is a cross-sectional view of the IGBT during the manufacturing process subsequent to FIG. 8.
[FIG. 10] FIG. 10 is a cross-sectional view of the IGBT during the manufacturing process subsequent to FIG. 9.
[FIG. 11] FIG. 11 is a cross-sectional view of an IGBT according to Modification Example 1.
[FIG. 12] FIG. 12 is a cross-sectional view of an IGBT according to Modification Example 2.
[FIG. 13] FIG. 13 is a cross-sectional view of a power MOSFET in Modification Example 3.
[FIG. 14] FIG. 14 is a cross-sectional view of a power MOSFET in Modification Example 4.
[FIG. 15] FIG. 15 is a cross-sectional view of a power MOSFET in Modification Example 5.
[FIG. 16] FIG. 16 is a cross-sectional view of a PN diode in Modification Example 6.
[FIG. 17] FIG. 17 is a cross-sectional view of a JBS diode in Modification Example 7.

### Description of Embodiments

Hereinafter, embodiments of the present disclosure will be described in detail with reference to the drawings. In all the drawings for describing the embodiments, members having the same functions are denoted by the same reference numerals, and repeated description thereof will be omitted. In the following embodiments, the description of the same or similar parts will not be repeated in principle unless otherwise necessary.

In the drawings used in the embodiments, hatching may be omitted or hatched in order to facilitate viewing of the drawings.

Also, although the embodiments are described in sufficient detail to enable those skilled in the art to practice the present disclosure, other implementations and forms are possible. It should be understood that changes in configuration and structure and replacement of various elements are possible without departing from the scope and spirit of the technical idea of the present disclosure. Therefore, the following description should not be interpreted as being limited thereto.

Silicon carbide (SiC) has many crystal polymorphs (polytypes) such as 3C-SiC, 4H-SiC, and 6H-SiC due to the difference in overlapping between the Si face and the C face. In the following embodiments, a silicon carbide layer (silicon carbide substrate) having a 3C-SiC crystal structure is referred to as 3C-SiC, and a silicon carbide layer (silicon carbide substrate) having a 4H-SiC crystal structure is referred to as 4H-SiC.

In addition, the expression "layer composed of..." means "a layer including.... as a main material", and includes a case where other impurities and the like are contained in the layer.

In addition, "p-type" means "p-type conductivity type", and "n-type" means "n-type conductivity type".

In addition, in the drawings of the embodiments and the modification examples, the first main surface side (upper side in the drawing) of the semiconductor substrate is referred to as "upper", and the second main surface side (lower side in the drawing) is referred to as "lower".

### (Embodiment)

### <Structure of IGBT of Present Embodiment>

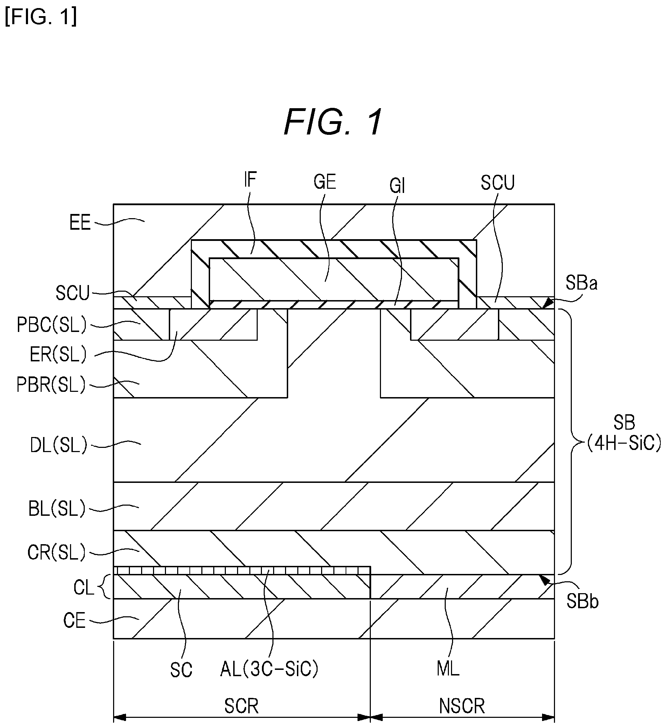

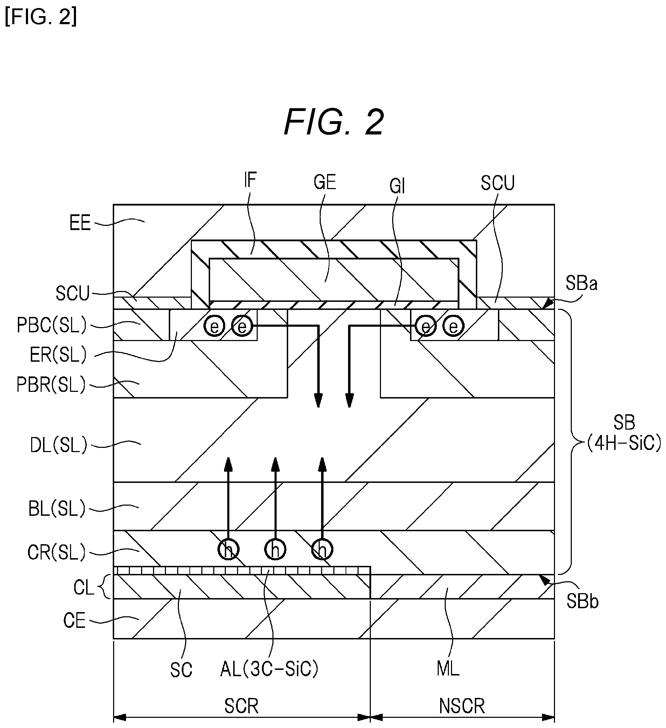

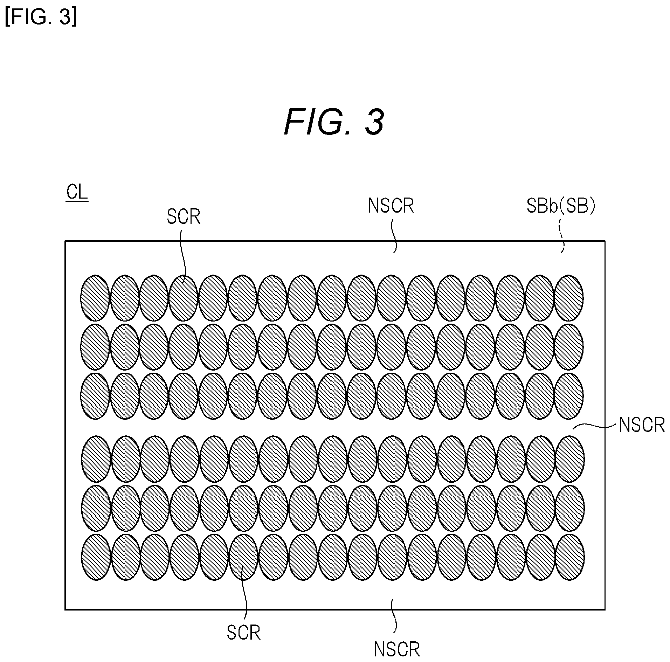

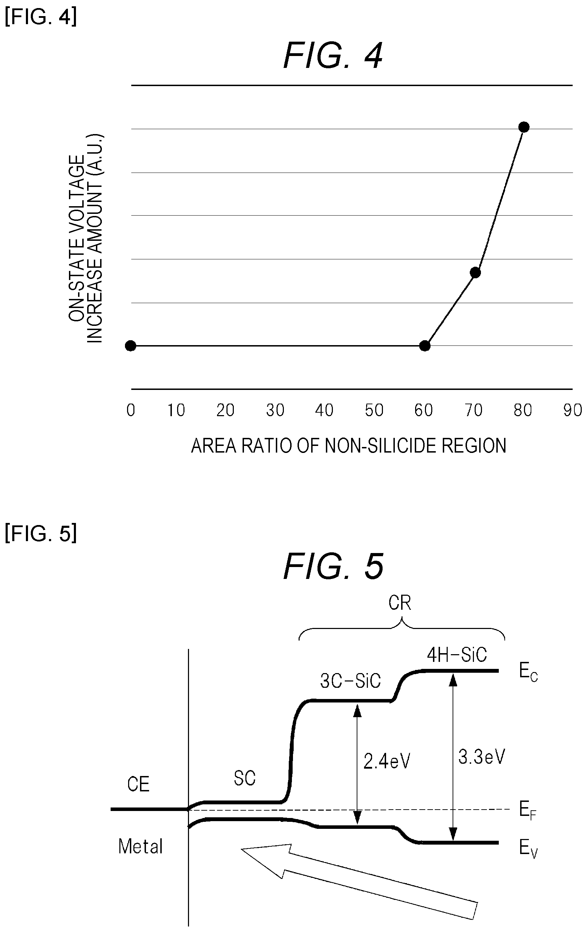

A silicon carbide semiconductor device (in particular, IGBTs) according to an embodiment will be described with reference to FIGS. 1 to 5. FIG. 1 is a cross-sectional view of an IGBT. FIG. 2 is a cross-sectional view for illustrating an operation (ON state) of the IGBT. FIG. 3 is a plan view of a contact layer of the IGBT. FIG. 4 is a view illustrating a relationship between an area ratio of a non-silicide region of a contact layer of an IGBT and an increase amount of an on-state voltage. FIG. 5 is an image diagram of a band diagram from a collector region to a collector electrode of the IGBT.

As illustrated in FIG. 1, the IGBT includes a semiconductor substrate SB made of 4H-SiC. The semiconductor substrate SB is an epitaxial substrate having a desired film thickness, and has a first main surface SBa and a second main surface SBb located on opposite sides in the film thickness direction. Here, the side on which an emitter electrode EE is formed is referred to as the first main surface SBa, and the side on which a collector electrode CE is formed is referred to as the second main surface SBb. Here, the side on which the emitter electrode EE is formed may be referred to as the second main surface SBa, and the side on which the collector electrode CE is formed may be referred to as the first main surface SBb. The semiconductor substrate SB includes a p-type collector region CR (sometimes referred to as a semiconductor layer SL), an n-type buffer layer BL (sometimes referred to as a semiconductor layer SL), and an n-type drift layer DL (sometimes referred to as a semiconductor layer SL) in this order from the second main surface SBb side toward the first main surface side. The drift layer DL is formed from the end portion of the buffer layer BL to the first main surface SBa. The p-type collector region CR is a p-type semiconductor region containing, for example, aluminum (Al) or boron (B) as a dopant. The n-type buffer layer BL and the n-type drift layer DL are n-type semiconductor regions containing, for example, nitrogen (N) or phosphorus (P) as dopants. The impurity concentration of the drift layer DL is lower than the impurity concentration of the buffer layer BL. Although depending on the element rating of the IGBT, the impurity concentration of the drift layer DL is preferably, for example, 1×10¹⁴ cm⁻³ or more and 1×10¹⁷ cm⁻³ or less. In addition, the film thickness of the drift layer DL is preferably, for example, 30 µm or more and 150 µm or less.

In the drift layer DL, a plurality of p-type body regions PBR (also referred to as semiconductor layers SL) are formed apart from each other from the first main surface SBa of the semiconductor substrate SB to an intermediate depth of the drift layer DL. In the p-type body region PBR, an n-type emitter region ER (sometimes referred to as the semiconductor layer SL) and a p-type body contact region PBC (sometimes referred to as the semiconductor layer SL) are formed. The n-type emitter region ER and the p-type body contact region PBC are formed from the first main surface SBa of the semiconductor substrate SB to an intermediate depth of the body region PBR. In the film thickness direction of the semiconductor substrate SB and the direction along the first main surface SBa, the emitter region ER is separated from the drift layer DL, and the body region PBR is interposed between the emitter region ER and the drift layer DL. The body region PBR and the body contact region PBC are p-type semiconductor regions containing, for example, aluminum (Al) or boron (B) as a dopant. The impurity concentration of the body contact region PBC is higher than the impurity concentration of the body region PBR. The emitter region ER is an n-type semiconductor region containing, for example, nitrogen (N) or phosphorus (P) as a dopant. The impurity concentration of the emitter region ER is higher than the impurity concentration of the drift layer DL.

A gate electrode GE is formed on the first main surface SBa of the semiconductor substrate SB via a gate insulating film GI to cover the body region PBR between emitter region ER and drift layer DL in the direction along first main surface SBa. The gate electrode GE is formed across the emitter region ER, the body region PBR, and the drift layer DL. The gate insulating film GI includes, for example, a silicon oxide film, and a film thickness thereof is preferably, for example, 0.05 µm or more and 0.15 µm or less. In addition, the gate electrode GE includes, for example, a polysilicon film, and a film thickness thereof is preferably, for example, 0.2 µm or more and 0.5 µm or less. An interlayer insulating film IF is formed on the gate electrode GE. The interlayer insulating film IF covers the upper surface and the side wall of the gate electrode GE.

A silicide layer SCU is formed in a region exposed from the interlayer insulating film IF on the first main surface SBa of the semiconductor substrate SB. The silicide layer SCU is in contact with the emitter region ER and the body contact region PBC. On the first main surface SBa of the semiconductor substrate SB, the emitter electrode EE is formed to cover the gate electrode GE, the emitter region ER, and the body contact region PBC. The emitter electrode EE is electrically separated from the gate electrode GE by the interlayer insulating film IF. The emitter electrode EE is connected to the emitter region ER and the body contact region PBC via the silicide layer SCU. The silicide layer SCU is formed to cover both the emitter region ER and the body contact region PBC, but may be formed to cover only one of the emitter region ER and the body contact region PBC. That is, the silicide layer SCU may have a structure in contact with only one of the emitter region ER and the body contact region PBC. The silicide layer SCU is, for example, nickel silicide (NiSi). The emitter electrode EE is a laminated film including, for example, a titanium (Ti) film, a titanium nitride (TiN) film, and an aluminum (Al) film in order from the silicide layer SCU side. It is preferable that the film thickness of the aluminum film be 1.0 µm or greater in order to reduce the resistance of the emitter electrode EE.

A contact layer CL is formed below the second main surface SBb of the semiconductor substrate SB to be in contact with the second main surface SBb, and the collector electrode CE is formed below the contact layer CL to be in contact with the contact layer CL. In the direction along the second main surface SBb, for example, the contact layer CL covers the entire region of the second main surface SBb, and the collector electrode CE covers the entire region of the contact layer CL.

In the direction along the second main surface SBb, the contact layer CL includes a silicide region SCR and a non-silicide region NSCR. A silicide layer SC is formed in the silicide region SCR, and a metal layer ML is formed in the non-silicide region NSCR. In addition, an altered layer AL which is an n-type semiconductor layer is formed in the collector region CR corresponding to the silicide region SCR. The altered layer AL is included in the collector region CR.

The silicide layer SC formed in the silicide region SCR which is a part of the contact layer CL is an alloy layer containing aluminum (Al), titanium (Ti), silicon (Si), carbon (C), and oxygen (O). As will be described later, the silicide layer SC is an alloy layer of a metal layer containing aluminum (Al) and titanium (Ti) and the semiconductor substrate SB made of 4H-SiC, in other words, the collector region CR (semiconductor layer SL) made of 4H-SiC. In the silicide region SCR, the silicide layer SC is sandwiched between the collector region CR (semiconductor layer SL) and the collector electrode CE, and is in contact with the collector region CR and the collector electrode CE. The metal layer ML formed in the non-silicide region NSCR which is a part of the contact layer CL contains, for example, aluminum (Al) and titanium (Ti). The metal layer ML may be a laminated film of an aluminum (Al) film and a titanium (Ti) film, or may be an alloy layer containing aluminum (Al) and titanium (Ti). In the non-silicide region NSCR, the metal layer ML is sandwiched between the collector region CR (semiconductor layer SL) and the collector electrode CE, and is in contact with the collector region CR and the collector electrode CE.

The altered layer AL is a part of the p-type collector region CR (semiconductor layer SL) made of 4H-SiC and is a p-type semiconductor layer SL made of 3C-SiC. The p-type semiconductor layer SL is obtained by modifying the crystal polymorph of the p-type collector region CR (semiconductor layer SL) made of 4H-SiC to 3C-SiC.

The collector electrode CE includes, for example, a laminated metal film of an aluminum (Al) film and a gold (Au) film. The aluminum (Al) film is in contact with the contact layer CL and is formed on the lower side of the contact layer CL. The aluminum (Al) film is formed to cover the entire area of the contact layer CL in the direction along the second main surface SBb, for example. The gold (Au) film is in contact with the aluminum (Al) film and is formed on the lower side of the aluminum (Al) film. The gold (Au) film is formed to cover, for example, the entire region of the aluminum (Al) film in the direction along the second main surface SBb.

That is, the IGBT has a laminated structure including the collector region CR (semiconductor layer SL) made of 4H-SiC, the altered layer AL made of 3C-SiC, the silicide layer SC, and the collector electrode CE in the silicide region SCR. In the silicide region SCR, the collector electrode CE is ohmically connected to the collector region CR (semiconductor layer SL) via the silicide layer SC. In other words, in the silicide region SCR, the collector electrode CE is ohmically connected to the collector region CR (semiconductor layer SL) including the altered layer AL made of 3C-SiC via the silicide layer SC. In the silicide region SCR, the collector region CR and the collector electrode CE are connected with a low resistance by interposing the silicide layer SC therebetween. In addition, the IGBT has a laminated structure including a collector region CR (semiconductor layer SL) made of 4H-SiC, a metal layer ML, and a collector electrode CE in the non-silicide region NSCR. In the non-silicide region NSCR, the metal layer ML is interposed between the collector region CR and the collector electrode CE, and the silicide layer SC is not interposed, so that the collector region CR and the collector electrode CE are connected with a higher resistance than the silicide region SCR.

Since the silicide layer SC is an alloy layer including the collector region CR (semiconductor layer SL) made of 4H-SiC and the metal film containing aluminum (Al) and titanium (Ti), the upper surface of the silicide layer SC may bite into the collector region CR (semiconductor layer SL) beyond the second main surface SBb.

### <Operation of IGBT>

The operation (ON state) of the IGBT will be described with reference to FIG. 2. Although not illustrated, in the ON state of the IGBT, for example, 0 V is applied to the emitter electrode EE, Vge (>Vth>0 V) is applied to the gate electrode GE, and Vce (>>0 V) is applied to the collector electrode CE. Vge represents a voltage of the gate electrode GE with respect to the emitter electrode EE, and Vce represents a voltage of the collector electrode CE with respect to the emitter electrode EE. Vth is a threshold voltage of a MOSFET (field effect transistor) including the gate electrode GE, the n-type emitter region ER, the n-type drift layer DL, and the p-type body region PBR. That is, a voltage higher than the threshold voltage Vth of the MOSFET is applied to the gate electrode GE, and a positive high voltage is applied to the collector electrode CE.

When Vge (>Vth) is applied to the gate electrode GE, an inversion layer is formed on the surface (first main surface SBa side) of the p-type body region PBR, and a large amount of electrons (e) flows into the n-type drift layer DL from the n-type emitter region ER. A part of the electrons (e) flowing into the drift layer DL flows into the p-type collector region CR. Simultaneously with the flow of the electrons (e), the PN junction including the p-type collector region CR, the n-type buffer layer BL, and the n-type drift layer DL becomes a forward bias, and a large amount of holes (h) are injected from the collector region CR into the drift layer DL. This corresponds to a current flowing from the collector electrode CE to the emitter electrode EE. Since a large amount of electrons (e) and holes (h) are injected into the drift layer DL, the concentration of electrons (e) and holes (h) in the n-type drift layer DL dramatically increases, and conductivity modulation of the n-type drift layer DL occurs. Therefore, since the on-resistance with respect to the current flowing from the collector electrode CE to the emitter electrode EE is lowered, the current driving capability of the IGBT is significantly improved.

As described above, when a large amount of holes (h) are injected from the collector region CR into the drift layer DL, the concentration of the holes (h) in the collector region CR decreases. Then, in order to replenish the holes (h) in the collector region CR, the holes (h) are injected from the collector electrode CE into the collector region CR via the contact layer CL. Here, the holes (h) are injected from the collector electrode CE into the collector region CR via the silicide region SCR of the contact layer CL. In the non-silicide region NSCR of the contact layer CL, injection of the holes (h) from the collector electrode CE to the collector region CR is not performed. As described above, in the silicide region SCR, the collector region CR and the collector electrode CE are in low resistance connection, and in the non-silicide region NSCR, the collector region CR and the collector electrode CE are in high resistance connection.

### <Regarding Contact Layer CL>

The contact layer CL will be described with reference to FIGS. 3 and 4. FIG. 3 is a plan view of the contact layer CL. As illustrated in FIG. 3, the contact layer CL includes the silicide region SCR and the non-silicide region NSCR. The silicide region SCR is configured by an aggregate of a plurality of units. The shape of each unit is, for example, an elliptical shape in plan view. The silicide region SCR includes a plurality of units arranged in a matrix. However, the shape and arrangement of the unit are not limited thereto.

Here, it is important that the contact layer CL includes both the silicide region SCR and the non-silicide region NSCR. When the entire region (in other words, the entire area of the second main surface SBb of the semiconductor substrate SB) of the contact layer CL is the silicide region SCR in plan view, the holes (h) injected from the collector electrode CE to the collector region CR are excessive. Therefore, by limiting the area of the silicide region SCR into which the holes (h) can be injected, the amount (in other words, the amount of the holes (h) injected into the drift layer DL) of the holes (h) injected from the collector electrode CE into the collector region CR is limited. In other words, limiting the area of the silicide region SCR leads to securing the area of the non-silicide region NSCR for the entire area of the contact layer CL (in other words, the entire area of the second main surface SBb of the semiconductor substrate SB) by a predetermined value. According to the study of the present inventors, it has been found that the area ratio of the non-silicide region NSCR is required to be 10% or more. Here, the area ratio of the non-silicide region NSCR is a ratio of the area of the non-silicide region NSCR to the area of the second main surface SBb of the semiconductor substrate SB.

Next, the reason why the non-silicide region NSCR is required in the contact layer CL will be described. The semiconductor substrate SB made of the aforementioned silicon carbide is generally formed by an epitaxial growth method. A defect called basal plane dislocation (BPD) exists in the semiconductor substrate SB made of silicon carbide. For example, when the BPD defect exists in the drift layer DL illustrated in FIG. 2, a large amount of the holes (h) are supplied to the drift layer DL, so that a planar laminating fault occurs with the BPD defect as a starting point. A phenomenon that the on-state voltage of the IGBT increases due to the planar laminating fault is called bipolar degradation. The bipolar degradation is a phenomenon peculiar to a bipolar device formed on a silicon carbide substrate. In the IGBT of the present embodiment, by setting the area ratio of the non-silicide region NSCR of the contact layer CL to 10% or more, injection of the holes (h) into the drift layer DL can be restricted, and the bipolar degradation can be suppressed.

FIG. 4 is a view illustrating a relationship between the area ratio of the non-silicide region NSCR of the contact layer CL and the increase amount of the on-state voltage of the IGBT. According to the study of the inventor of the present application, it has been confirmed that the on-state voltage of the IGBT significantly increases when the area ratio of the non-silicide region NSCR exceeds 60%. That is, it is important to set the area ratio of the non-silicide region NSCR to 60% or less. Therefore, in order to suppress the bipolar degradation and reduce the on-state voltage of the IGBT, it is important to set the area ratio of the non-silicide region NSCR to 10% or more and 60% or less.

### <Regarding Altered Layer AL>

As illustrated in FIG. 1, the IGBT of the present embodiment has a laminated structure including the collector region CR made of 4H-SiC, the altered layer AL made of 3C-SiC, the silicide layer SC, and the collector electrode CE in the silicide region SCR. FIG. 5 is an image diagram of a band diagram from the collector region CR to the collector electrode CE of the IGBT. That is, the band diagram corresponds to a band diagram of a laminated structure formed in the silicide region SCR. FIG. 5 illustrates the p-type collector region CR made of 4H-SiC, the p-type collector region CR made of 3C-SiC (corresponding to the altered layer AL in FIG. 1), a conduction band lower end E_{C}, a Fermi level E_{F}, and a valence band upper end E_{V} in the silicide layer SC and the collector electrode CE. The width between the conduction band lower end E_{C} and the valence band upper end E_{V} is a band gap. The band gap (2.4 eV) of the p-type collector region CR made of 3C-SiC is smaller than the band gap (3.3 eV) of the p-type collector region CR made of 4H-SiC. By interposing the collector region CR made of 3C-SiC having a small band gap (corresponding to the altered layer AL in FIG. 1) between the collector region CR made of 4H-SiC and the silicide layer SC, the band diagram (here, the valence band upper end E_{V}) between the p-type collector region CR made of 4H-SiC and the collector electrode CE becomes stepwise, and the resistance between the collector region CR made of 4H-SiC and the collector electrode CE can be reduced.

### <Features of IGBT of Present Embodiment>

As illustrated in FIG. 1, the IGBT of the present embodiment has a laminated structure including the collector region CR (semiconductor layer SL) made of 4H-SiC, the altered layer AL made of 3C-SiC, the silicide layer SC, and the collector electrode CE in the silicide region SCR. Therefore, in the silicide region SCR, the collector electrode CE is ohmically connected to the collector region CR (semiconductor layer SL) via the silicide layer SC. In addition, by interposing a collector region CR made of 3C-SiC having a smaller band gap (corresponding to the altered layer AL in FIG. 1) between the collector region CR made of 4H-SiC and the silicide layer SC, the resistance between the p-type collector region CR made of 4H-SiC and the collector electrode CE can be reduced. That is, the ON resistance of the IGBT can be reduced.

As illustrated in FIG. 1, the IGBT of the present embodiment includes the contact layer CL between the collector region CR and the collector electrode CE. The contact layer CL includes the silicide region SCR and the non-silicide region NSCR, and the area ratio of the non-silicide region NSCR is 10% or more and 60% or less. Therefore, the bipolar degradation can be suppressed, and the on-state voltage of the IGBT can be reduced.

### <Manufacturing Method of IGBT of Present Embodiment>

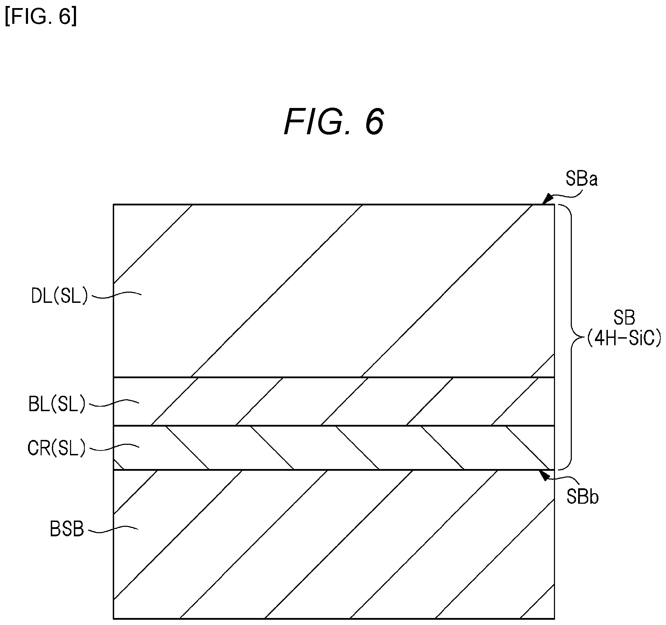

A manufacturing method of the IGBT according to the present embodiment will be described with reference to FIGS. 6 to 10. FIGS. 6 to 10 are cross-sectional views of the IGBT during the manufacturing process.

First, as illustrated in FIG. 6, a base substrate BSB is prepared. The base substrate BSB is a silicon carbide substrate made of 4H-SiC and contains n-type impurities (for example, nitrogen (N)). An impurity concentration of the n-type impurity ranges from 1×10¹⁸ cm⁻³ to 1×10²¹ cm⁻³. The surface of the silicon carbide substrate may be either a Si surface or a C surface. Next, the p-type collector region CR, the n-type buffer layer BL, and the n-type drift layer DL are sequentially formed on the base substrate BSB by an epitaxial growth method. The p-type collector region CR, the n-type buffer layer BL, and the n-type drift layer DL constitute a semiconductor substrate SB, and the semiconductor substrate SB is an epitaxial substrate and is a silicon carbide substrate made of 4H-SiC. Each of the p-type collector region CR, the n-type buffer layer BL, and the n-type drift layer DL is a silicon carbide layer (semiconductor layer SL) made of 4H-SiC.

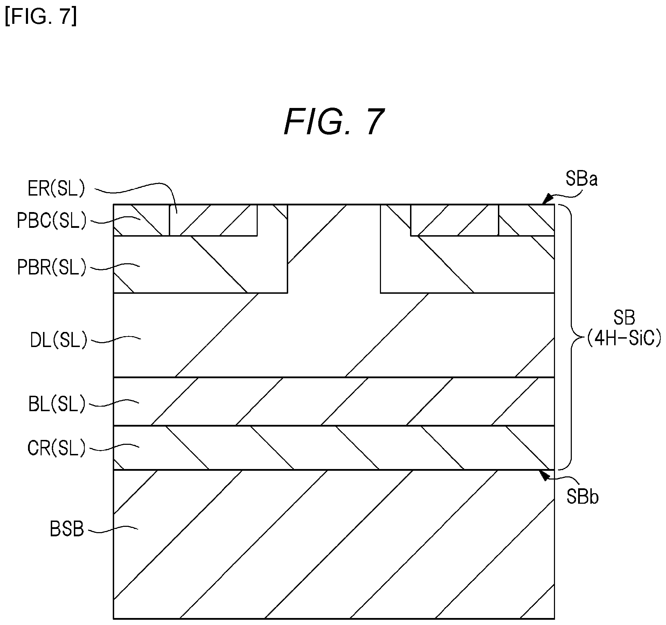

Next, as illustrated in FIG. 7, the p-type body region PBR, the n-type emitter region ER, and the p-type body contact region PBC are formed in the drift layer DL. The body region PBR, the emitter region ER, and the body contact region PBC are formed using an ion implantation method. These formation portions are as described with reference to FIG. 1.

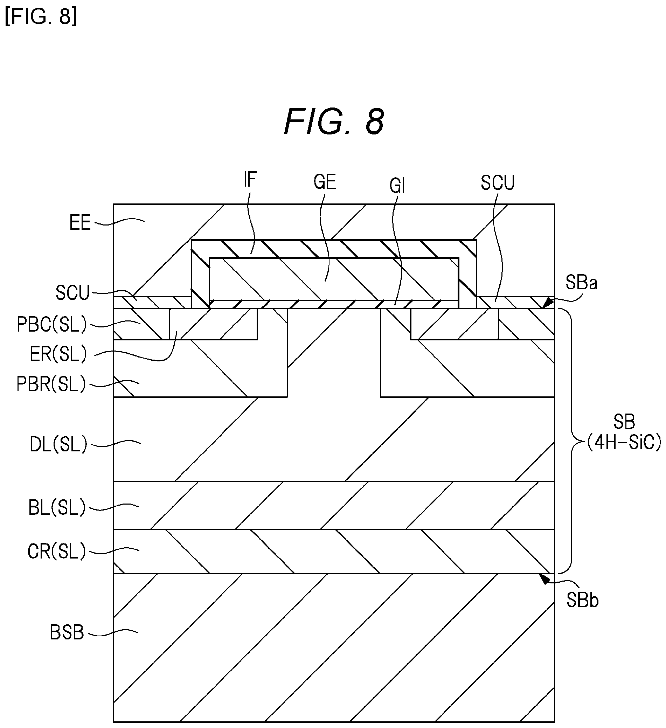

Next, as illustrated in FIG. 8, the gate electrode GE is formed on the first main surface via the gate insulating film GI. The gate insulating film GI is, for example, a thermal oxide film (silicon oxide film) or a CVD oxide film (silicon oxide film) formed using a thermal oxidation method or a chemical vapor deposition (CVD) method. The gate insulating film GI may be a laminated film of a thermal oxide film and a CVD oxide film formed on the thermal oxide film. The gate electrode GE is formed by patterning a polysilicon film deposited on the gate insulating film GI. Note that a photolithography technique and an etching method are used for patterning the polysilicon film. The polysilicon film constituting the gate electrode GE contains n-type or p-type impurities. The thickness of the gate insulating film GI is, for example, 0.05 µm or more and 0.15 µm or less. In addition, the thickness of the gate electrode GE is, for example, 0.2 µm or more and 0.5 µm or less.

Next, as illustrated in FIG. 8, the interlayer insulating film IF is formed. The interlayer insulating film IF covers the upper surface of the gate electrode GE and the side surfaces of the gate electrode GE and the gate insulating film GI. The interlayer insulating film IF is formed by, for example, a plasma CVD method to cover the first main surface SBa and the gate electrode GE. Next, the interlayer insulating film IF is processed using the photolithography technique and the etching method to expose the emitter region ER and the body contact region PBC on the first main surface SBa.

Next, as illustrated in FIG. 8, the silicide layer SCU is formed on the surfaces of the exposed emitter region ER and body contact region PBC. The silicide layer SCU is, for example, nickel silicide (NiSi). For example, a nickel (Ni) film having a film thickness of about 0.05 µm is deposited on the first main surface SBa, and then heat treatment is performed at 600°C or higher and 1000°C or lower to form a silicide layer SCU on the surfaces of the emitter region ER and the body contact region PBC.

Next, as illustrated in FIG. 8, the emitter electrode EE is formed on the interlayer insulating film IF and the silicide layer SCU. The emitter electrode EE is made of a laminated film in which a titanium (Ti) film, a titanium nitride (TiN) film, and an aluminum (Al) film are laminated in this order on the first main surface SBa. The emitter electrode EE is electrically connected to the emitter region ER and the body contact region PBC via the silicide layer SCU.

Next, the base substrate BSB illustrated in FIG. 8 is removed using a grinding technique to expose the second main surface SBb of the semiconductor substrate SB. Here, the gate electrode GE, the emitter electrode EE, and the like were formed on the semiconductor substrate SB, and then the base substrate BSB was removed. However, in a case where the semiconductor substrate SB has sufficient strength, the gate electrode GE, the emitter electrode EE, and the like may be formed on the semiconductor substrate SB after the base substrate BSB is removed. When a p-type silicon carbide substrate is used as the base substrate BSB, it is not necessary to completely remove the base substrate BSB. In addition, the grinding process of the base substrate BSB may be omitted.

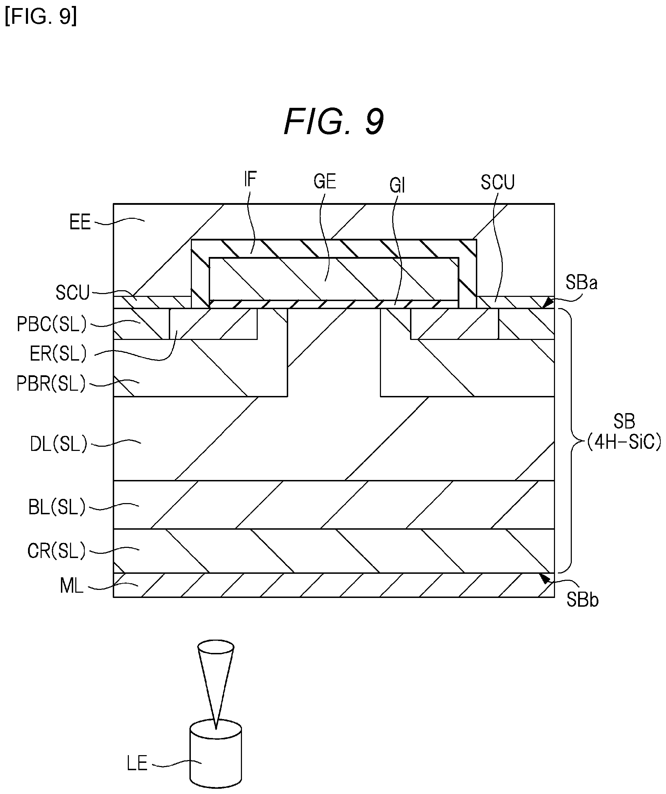

Next, as illustrated in FIG. 9, the metal layer ML is formed on the lower side of the second main surface SBb. For example, the metal layer ML is a laminated film (two-layer film) of an aluminum (Al) film in contact with the collector region CR on the second main surface SBb and a titanium (Ti) film in contact with the aluminum (Al) film on the lower side of the aluminum (Al) film. The laminated film may be a three-layer film. For example, a nickel (Ni) film, a molybdenum (Mo) film, a cobalt (Co) film, a titanium nitride (TiN) film, a gold (Au) film, a germanium (Ge) film, or a tungsten (W) film may be further provided on the lower side of the titanium (Ti) film in contact with the lower side of the aluminum (Al) film. The total thickness of the laminated film is preferably 50 nm or more and 300 nm or less. In addition, the metal layer ML may be an alloy layer containing aluminum (Al) and titanium (Ti).

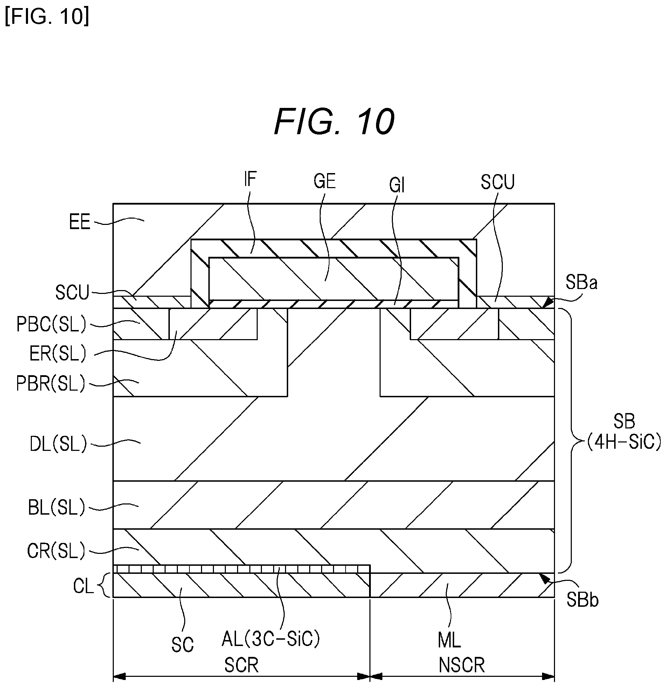

Next, as illustrated in FIG. 9, a laser annealing treatment is performed on the IGBT by a laser device LE. That is, the metal layer ML is selectively irradiated with the laser beam from the metal layer ML side toward the collector region CR. The silicide region SCR illustrated in FIG. 3 is irradiated with the laser beam. The unit described with reference to FIG. 3 shows the irradiation region of the laser beam per irradiation. Then, as illustrated in FIG. 10, the contact layer CL including the silicide region SCR and the non-silicide region NSCR and the altered layer AL made of 3C-SiC are formed. The silicide layer SC and the altered layer AL are formed in the silicide region SCR irradiated with the laser beam. In the non-silicide region NSCR not irradiated with the laser beam, the silicide layer SC and the altered layer AL are not formed, and the metal layer ML remains. Therefore, the laser irradiation condition needs to be set to energy equivalent to or higher than the band gap of 4H-SiC in order to form the altered layer AL made of 3C-SiC. The wavelength of the laser beam is preferably, for example, 290 nm or more and 600 nm or less. The irradiation intensity of the laser beam is preferably 3.0 J/cm² or more and 3.5 J/cm² or less. When the irradiation intensity is too low, aluminum (Al) of the metal layer ML does not react with SiC in the collector region CR, and when the irradiation intensity is too high, the silicide layer SC may disappear from SiC in the collector region CR. As described above, the area ratio of the non-silicide region NSCR not irradiated with the laser beam is set to 10% or more and 60% or less.

In the laser annealing treatment, it is important to irradiate the titanium (Ti) film, the nickel (Ni) film, the molybdenum (Mo) film, the cobalt (Co) film, the titanium nitride (TiN) film, the gold (Au) film, the germanium (Ge) film, or the tungsten (W) film with a laser beam without directly irradiating the aluminum (Al) film included in the metal layer ML with the laser beam. This is because the aluminum (Al) film has a high reflectance to the laser beam, and the effect of laser irradiation is weakened.

Next, as illustrated in FIG. 1, the collector electrode CE is formed on the lower side of the contact layer CL.

### <Features of Manufacturing Method of IGBT of Present Embodiment>

As described with reference to FIGS. 9 and 10, the metal layer ML is selectively irradiated with a laser beam, the silicide layer SC is formed in the silicide region SCR of the contact layer CL, and the altered layer AL made of 3C-SiC is formed in a part of the collector region CR made of 4H-SiC. The IGBT thus manufactured has, in the silicide region SCR, a laminated structure including the collector region CR made of 4H-SiC, the altered layer AL made of 3C-SiC, the silicide layer SC, and the collector electrode CE. Therefore, in the silicide region SCR, the collector electrode CE is ohmically connected to the collector region CR via the silicide layer SC. In addition, since the altered layer AL made of 3C-SiC is interposed between the p-type collector region CR made of 4H-SiC and the silicide layer SC, resistance between the p-type collector region CR and the collector electrode CE can be reduced. That is, the ON resistance of the IGBT can be reduced.

In addition, in the laser annealing treatment process, the efficiency of the laser annealing can be improved by irradiating the titanium (Ti) film, the nickel (Ni) film, the molybdenum (Mo) film, the cobalt (Co) film, the titanium nitride (TiN) film, the gold (Au) film, the germanium (Ge) film, or the tungsten (W) film covering the aluminum (Al) film with the laser beam without directly irradiating the aluminum (Al) film included in the metal layer ML with the laser beam.

By setting the area ratio of the non-silicide region NSCR to 10% or more and 60% or less, it is possible to suppress the bipolar degradation and reduce the on-state voltage of the IGBT.

### <Structure of IGBT of Modification Example 1>

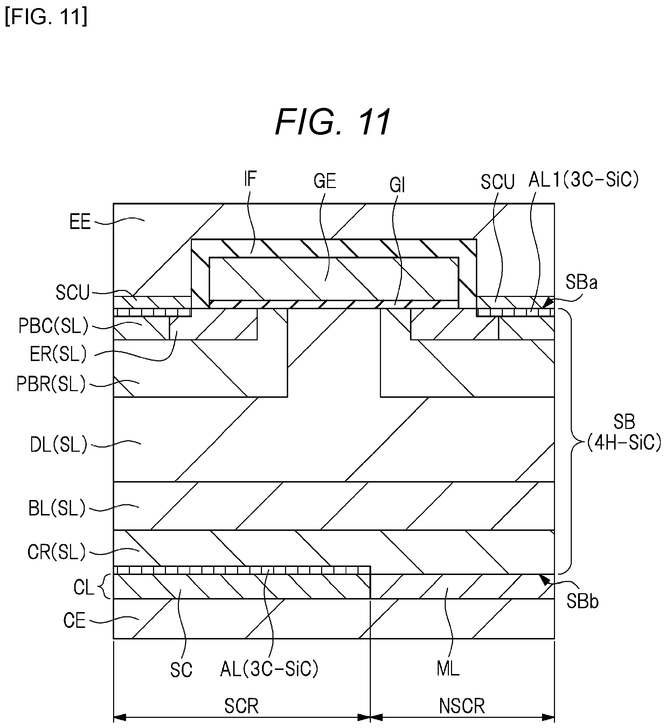

A structure of the IGBT which is a silicon carbide semiconductor device according to Modification Example 1 will be described. FIG. 11 is a cross-sectional view of an IGBT according to Modification Example 1. The structure of the IGBT of Modification Example 1 is obtained by adding an altered layer AL1 to the IGBT of the above embodiment. As illustrated in FIG. 11, the IGBT of Modification Example 1 has the altered layer AL1 made of 3C-SiC between the emitter region ER, the body contact region PBC, and the silicide layer SCU.

The IGBT in Modification Example 1 has a laminated structure including a p-type body contact region PBC, the altered layer AL1 made of 3C-SiC, the silicide layer SCU, and the emitter electrode EE. Since the altered layer AL1 made of 3C-SiC having a small band gap is interposed between the p-type body contact region PBC made of 4H-SiC and the silicide layer SCU, resistance between the p-type body contact region PBC made of 4H-SiC and the emitter electrode EE can be reduced.

The IGBT in Modification Example 1 has a laminated structure including the n-type emitter region ER, the altered layer AL1 made of 3C-SiC, the silicide layer SCU, and the emitter electrode EE. Since the altered layer AL1 made of 3C-SiC having a small band gap is interposed between the n-type emitter region ER made of 4H-SiC and the silicide layer SCU, resistance between the n-type emitter region ER made of 4H-SiC and the emitter electrode EE can be reduced. In the description of FIG. 5, when the collector region CR is replaced with the n-type emitter region ER and the collector electrode CE is replaced with the emitter electrode EE, it can be considered that a band diagram (here, the conduction band lower end E_{C}) between the n-type emitter region ER made of 4H-SiC and the emitter electrode EE has a stepwise shape.

In Modification Example 1, the altered layer AL1 made of 3C-SiC is provided between the emitter region ER and the body contact region PBC, and the silicide layer SCU. However, the altered layer AL1 may be provided between one of the emitter region ER and the body contact region PBC, and the emitter electrode EE.

### <Structure of IGBT of Modification Example 2>

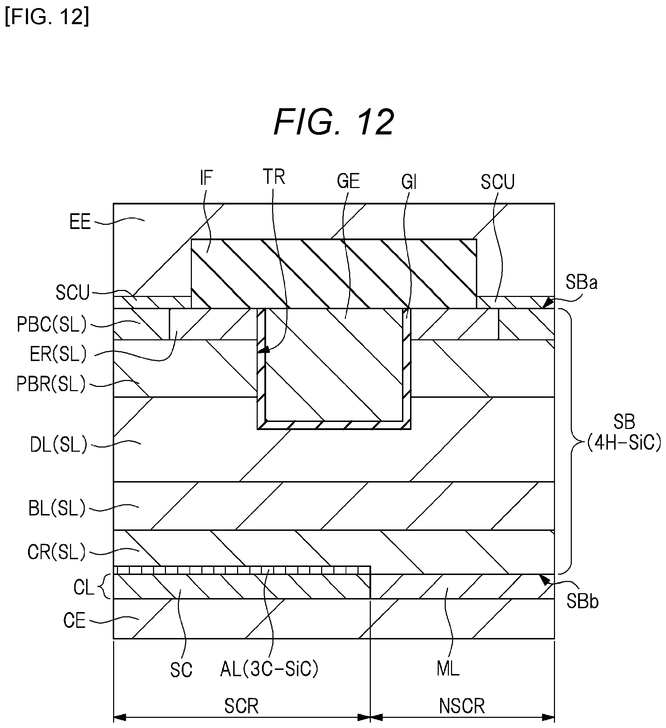

A structure of a trench gate type IGBT which is a silicon carbide semiconductor device according to Modification Example 2 will be described. FIG. 12 is a cross-sectional view of an IGBT according to Modification Example 2. In the IGBT of Modification Example 2, the gate electrode GE of the IGBT of the above embodiment is disposed in a trench TR provided on the first main surface SBa. The trench TR extends from the first main surface SBa toward the second main surface SBb, penetrates the body region PBR, and reaches the drift layer DL. In the trench TR, the gate electrode GE is formed via the gate insulating film GI. The IGBT is similar to the IGBT of the above embodiment except for the structure of the gate electrode GE of the IGBT in Modification Example 2, and thus has the same effect as the IGBT of the above embodiment. In addition, the altered layer AL1 of Modification Example 1 may be added to the trench gate type IGBT of Modification Example 2.

### <Structure of Power MOSFET of Modification Example 3>

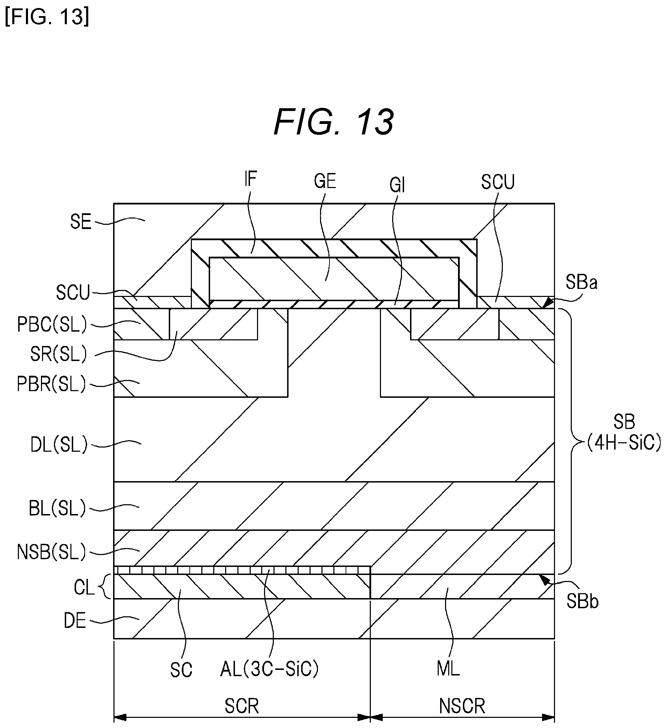

In Modification Example 3, the contact layer CL and the altered layer AL, which are features of the above embodiment, are applied to a power MOSFET. FIG. 13 is a cross-sectional view of a power MOSFET in Modification Example 3. The power MOSFET of Modification Example 3 has a structure in which the p-type collector region CR, the collector electrode CE, the n-type emitter region ER, and the emitter electrode EE of the IGBT of the above embodiment are replaced with an n-type substrate region NSB, a drain electrode DE, an n-type source region SR, and a source electrode SE. The n-type substrate region NSB and the n-type source region SR are n-type semiconductor regions. A member of the drain electrode DE is equal to a member of the collector electrode CE, and a member of the source electrode SE is equal to a member of the emitter electrode EE.

The power MOSFET of Modification Example 3 has a laminated structure including the n-type substrate region NSB (semiconductor layer SL) made of 4H-SiC, the altered layer AL made of 3C-SiC, the silicide layer SC, and the drain electrode DE in the silicide region SCR. Since the altered layer AL made of 3C-SiC having a small band gap is interposed between the n-type substrate region NSB made of 4H-SiC and the silicide layer SC, resistance between the n-type substrate region NSB made of 4H-SiC and the drain electrode DE can be reduced.

### <Structure of Power MOSFET of Modification Example 4>

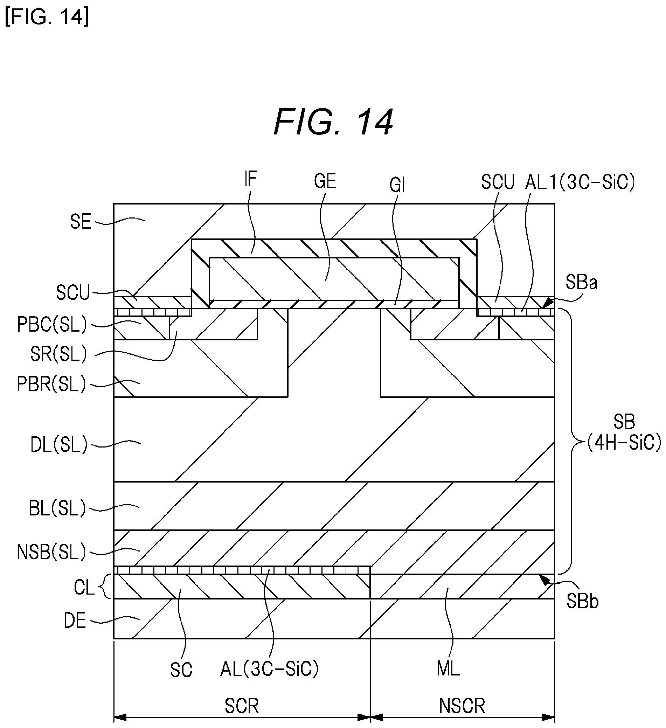

Modification Example 4 is a modification example to Modification Example 3, and has a structure in which the altered layer AL1 is added to the power MOSFET of Modification Example 3. FIG. 14 is a cross-sectional view of a power MOSFET in Modification Example 4.

The power MOSFET in Modification Example 4 has a laminated structure including the p-type body contact region PBC, the altered layer AL1 made of 3C-SiC, the silicide layer SCU, and the source electrode SE. Since the altered layer AL1 made of 3C-SiC having a small band gap is interposed between the p-type body contact region PBC made of 4H-SiC and the silicide layer SCU, resistance between the p-type body contact region PBC made of 4H-SiC and the source electrode SE can be reduced.

The power MOSFET in Modification Example 4 has a laminated structure including the n-type source region SR, the altered layer AL1 made of 3C-SiC, the silicide layer SCU, and the source electrode SE. Since the altered layer AL1 made of 3C-SiC having a small band gap is interposed between the n-type source region SR made of 4H-SiC and the silicide layer SCU, resistance between the n-type source region SR made of 4H-SiC and the source electrode SE can be reduced.

In Modification Example 4, the altered layer AL1 made of 3C-SiC is provided between the source region SR and the body contact region PBC, and the silicide layer SCU. However, the altered layer AL1 may be provided between one of the source region SR and the body contact region PBC, and the source electrode SE.

### <Structure of Power MOSFET of Modification Example 5>

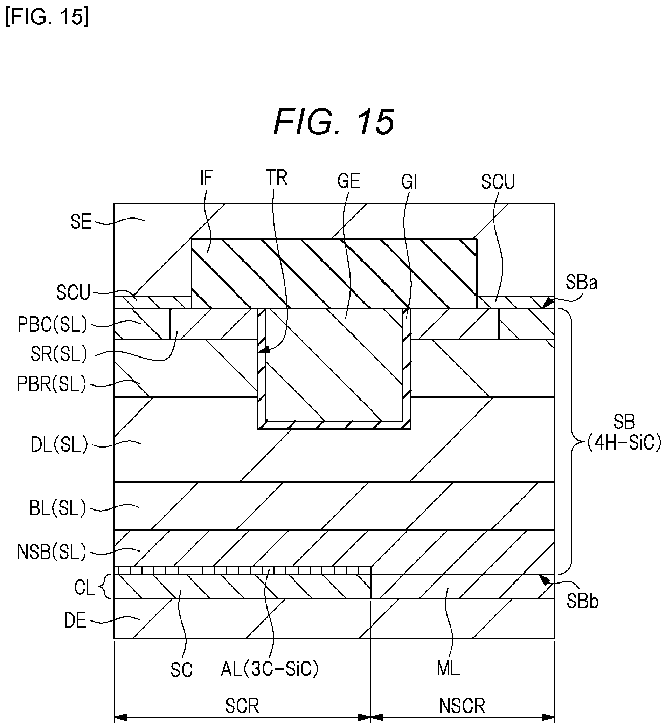

Modification Example 5 is a modification example to Modification Example 3, and is a trench gate type power MOSFET. The gate electrode GE of the power MOSFET of Modification Example 3 is disposed in the trench TR provided in the first main surface SBa. FIG. 15 is a cross-sectional view of a power MOSFET in Modification Example 5. The trench TR extends from the first main surface SBa toward the second main surface SBb, penetrates the body region PBR, and reaches the drift layer DL. In the trench TR, the gate electrode GE is formed via the gate insulating film GI. Since the configuration is similar to that of Modification Example 3 except for the structure of the gate electrode GE of the power MOSFET in Modification Example 5, the power MOSFET has the same effect as that of the power MOSFET in Modification Example 3 above.

### <Structure of PN Diode of Modification Example 6>

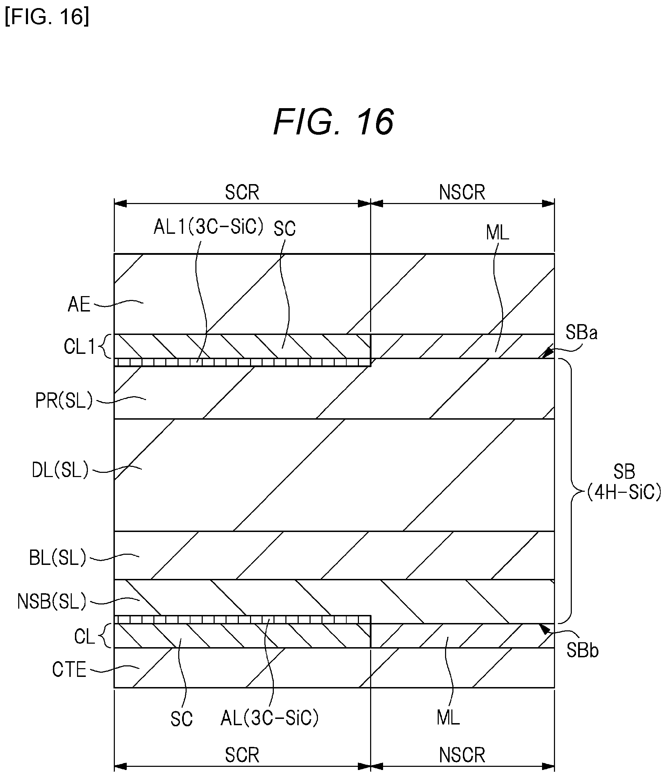

In Modification Example 6, the contact layer CL and the altered layer AL, which are features of the above embodiment, are applied to a PN diode. FIG. 16 is a cross-sectional view of a PN diode in Modification Example 6. In the PN diode in Modification Example 6, a contact layer CL1 and the altered layer AL1 are also provided on an anode electrode AE side. However, the contact layer CL and the altered layer AL may be provided only on a cathode electrode CTE side. In addition, the contact layer CL1 and the altered layer AL1 may be provided only on the anode electrode AE side.

The PN diode includes the semiconductor substrate SB, the contact layers CL and CL1, the cathode electrode CTE, and the anode electrode AE. The semiconductor substrate SB made of 4H-SiC has the first main surface SBa and the second main surface SBb. Further, the semiconductor substrate SB includes the n-type substrate region NSB (also referred to as the semiconductor layer SL), the n-type buffer layer BL (also referred to as the semiconductor layer SL), the n-type drift layer DL (also referred to as the semiconductor layer SL), and a p-type semiconductor region PR (also referred to as the semiconductor layer SL) in a direction from the second main surface SBb toward the first main surface SBa. The contact layer CL is formed below the n-type substrate region NSB, and the cathode electrode CTE is formed below the contact layer CL. The contact layer CL includes the silicide region SCR and the non-silicide region NSCR, the silicide layer SC is formed in the silicide region SCR, and the metal layer ML is formed in the non-silicide region NSCR. The area ratio of the non-silicide region NSCR is 10% or more and 60% or less. Furthermore, in a region corresponding to the silicide region SCR, the altered layer AL made of 3C-SiC is formed in the n-type substrate region NSB, and the altered layer AL is in contact with the silicide layer SC.

The PN diode of Modification Example 6 has a laminated structure including the n-type substrate region NSB (semiconductor layer SL) made of 4H-SiC, the altered layer AL made of 3C-SiC, the silicide layer SC, and the cathode electrode CTE in the silicide region SCR on the cathode electrode CTE side. Since the altered layer AL made of 3C-SiC having a small band gap is interposed between the n-type substrate region NSB made of 4H-SiC and the silicide layer SC, resistance between the n-type substrate region NSB made of 4H-SiC and the cathode electrode CTE can be reduced.

In addition, the contact layer CL1 is formed above the p-type semiconductor region PR, and the anode electrode AE is formed above the contact layer CL1. The contact layer CL1 includes the silicide region SCR and the non-silicide region NSCR, the silicide layer SC is formed in the silicide region SCR, and the metal layer ML is formed in the non-silicide region NSCR. The area ratio of the non-silicide region NSCR is 10% or more and 60% or less. Here, the area ratio of the non-silicide region NSCR is a ratio of the area of the non-silicide region NSCR to the area of the first main surface SBa of the semiconductor substrate SB. Furthermore, in the region corresponding to the silicide region SCR, the altered layer AL1 made of 3C-SiC is formed in the p-type semiconductor region PR. A member of the cathode electrode CTE is equal to a member of the collector electrode CE (see FIG. 1), and a member of the anode electrode AE is equal to a member of the emitter electrode EE (see FIG. 1).

The PN diode of Modification Example 6 has a laminated structure including the p-type semiconductor region PR (semiconductor layer SL) made of 4H-SiC, the altered layer AL1 made of 3C-SiC, the silicide layer SC, and the anode electrode AE in the silicide region SCR on the anode electrode AE side. Therefore, in the silicide region SCR, the anode electrode AE is ohmically connected to the p-type semiconductor region PR (semiconductor layer SL) via the silicide layer SC. In addition, since the altered layer AL1 made of 3C-SiC having a small band gap is interposed between the p-type semiconductor region PR made of 4H-SiC and the silicide layer SC, resistance between the p-type semiconductor region PR made of 4H-SiC and the anode electrode AE can be reduced. In the contact layer CL1, the area ratio of the non-silicide region NSCR is set to 10% or more and 60% or less. Therefore, the bipolar degradation can be suppressed in the PN diode. Since the PN diode of Modification Example 6 is a bipolar device, limiting the area ratio of the non-silicide region NSCR leads to suppression of the bipolar degradation.

In addition, a plurality of trenches shallower than the depth of the p-type semiconductor region PR may be provided in the first main surface SBa, and the contact layer CL1 and the anode electrode AE may be provided on the first main surface SBa including the concave portion and the convex portion.

### <Structure of JBS Diode of Modification Example 7>

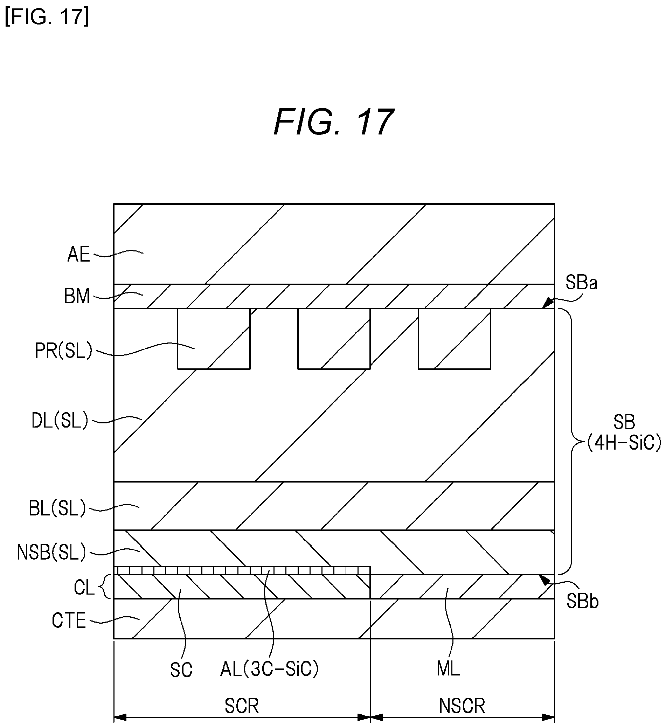

In Modification Example 7, the contact layer CL and the altered layer AL, which are features of the above embodiment, are applied to a junction barrier shottky (JBS) diode. FIG. 17 is a cross-sectional view of the JBS diode in Modification Example 7. Since the structure of the JBS diode is similar to the structure of the PN diode of Modification Example 6, the difference between the two will be described. In the JBS diode, a plurality of p-type semiconductor regions PR are formed apart from each other on the first main surface SBa of the semiconductor substrate SB, and the n-type drift layer DL is exposed between the plurality of p-type semiconductor regions PR on the first main surface SBa. A barrier metal layer BM is formed on the first main surface SBa, and the anode electrode AE is formed on the barrier metal layer BM. The barrier metal layer BM is made of, for example, molybdenum (Mo), titanium (Ti), or vanadium (V).

The JBS diode of Modification Example 7 has a laminated structure including the n-type substrate region NSB (semiconductor layer SL) made of 4H-SiC, the altered layer AL made of 3C-SiC, the silicide layer SC, and the cathode electrode CTE in the silicide region SCR on the cathode electrode CTE side. Since the altered layer AL made of 3C-SiC having a small band gap is interposed between the n-type substrate region NSB made of 4H-SiC and the silicide layer SC, resistance between the n-type substrate region NSB made of 4H-SiC and the cathode electrode CTE can be reduced.

In addition, a plurality of trenches shallower than the depth of the p-type semiconductor region PR may be provided in the first main surface SBa, and the barrier metal layer BM and the anode electrode AE may be formed on the first main surface SBa including the concave portion and the convex portion.

Although not illustrated, in the JBS diode of the further modification example of Modification Example 7, the barrier metal layer BM may be provided only on the n-type drift layer DL, and the silicide layer SC may be provided on the p-type semiconductor region PR. That is, the first laminated structure includes the n-type drift layer DL, the barrier metal layer BM, and the anode electrode AE, and the second laminated structure includes the p-type semiconductor region PR, the silicide layer SC, and the anode electrode AE. Furthermore, in the second laminated structure, the altered layer AL1 may be interposed between the p-type semiconductor region PR and the silicide layer SC.

In addition, a plurality of trenches shallower than the depth of the p-type semiconductor region PR may be provided in the first main surface SBa, the barrier metal layer BM may be provided in the convex portion in the first main surface SBa including the concave portion and the convex portion, and the silicide layer SC may be provided in the concave portion.

In addition, when a metal having a Schottky barrier with the n-type drift layer DL is selected as the metal layer of the anode electrode AE, the barrier metal layer BM may be omitted.

Although the invention of the present application has been specifically described above based on the embodiments, the invention of the present application is not limited to the above-described embodiments or modification examples, and various modifications can be made without departing from the gist of the invention.

In addition, some of the contents described in the above embodiment will be described below.

### [Supplementary Note]

### (Supplementary Note 1)

A manufacturing method of a silicon carbide semiconductor device including
a process (a) of preparing a base substrate made of 4H-SiC,
a process (b) of forming a semiconductor layer on the base substrate,
a process (c) of forming, on the semiconductor layer, a device structure of the silicon carbide semiconductor device including a gate electrode and an emitter electrode,
a process (d) of exposing the semiconductor layer by grinding the base substrate,
a process (e) of forming a metal layer so as to be in contact with the exposed semiconductor layer,
a process (f) of selectively irradiating the metal layer with a laser beam to form a contact layer including a silicide region and a non-silicide region, and
a process (g) of forming an electrode on the contact layer, in which
in the process (f), a silicide layer including the metal layer is formed in the silicide region where the metal layer is irradiated with the laser beam, the metal layer is left in the non-silicide region where the metal layer is not irradiated with the laser beam, and an altered layer made of 3C-SiC is formed at a boundary between the semiconductor layer and the silicide layer in the silicide region.

### Reference Signs List

- AE: anode electrode
- AL, AL1: altered layer
- BL: buffer layer
- BM: barrier metal layer
- BSB: base substrate
- CE: collector electrode
- CL, CL1: contact layer
- CR: collector region
- CTE: cathode electrode
- DE: drain electrode
- DL: drift layer
- DR: drain region
- EE: emitter electrode
- ER: emitter region
- GE: gate electrode
- GI: gate insulating film
- IF: interlayer insulating film
- LE: laser device
- ML: metal layer
- NSB: n-type substrate region
- NSCR: non-silicide region
- PBC: body contact region
- PBR: body region
- PR: p-type semiconductor region
- SB: semiconductor substrate
- SBa: first main surface
- SBb: second main surface
- SC, SCU: silicide layer
- SCa: upper surface
- SCb: lower surface
- SCR: silicide region
- SE: source electrode
- SL: semiconductor layer
- SR: source region
- TR: trench

## Claims

1. A silicon carbide semiconductor device comprising:
a semiconductor substrate made of 4H-SiC and having a first main surface and a second main surface positioned on opposite sides in a thickness direction;
a first semiconductor layer formed in the semiconductor substrate at the second main surface of the semiconductor substrate;
a contact layer that is in contact with the second main surface of the semiconductor substrate and includes a silicide region and a non-silicide region; and
a first electrode that is in contact with the contact layer and formed on a side opposite to the semiconductor substrate with respect to the contact layer, wherein
a first silicide layer having an upper surface and a lower surface is formed in the silicide region,
a first altered layer made of 3C-SiC is interposed between the upper surface of the first silicide layer and the first semiconductor layer, and
the lower surface of the first silicide layer is in contact with the first electrode.

2. The silicon carbide semiconductor device according to claim 1, wherein the first silicide layer in the contact layer is an alloy layer containing aluminum, titanium, silicon, and carbon.

3. The silicon carbide semiconductor device according to claim 2, wherein the non-silicide region in the contact layer is a metal layer containing aluminum and titanium.

4. The silicon carbide semiconductor device according to claim 3, wherein the first electrode includes an aluminum film.

5. The silicon carbide semiconductor device according to claim 1, wherein, in a plan view, an area of the non-silicide region is 10% or more and 60% or less of an area of the second main surface of the semiconductor substrate.

6. The silicon carbide semiconductor device according to claim 1, further comprising:
an insulated gate bipolar transistor having a collector electrode, an emitter electrode, and a gate electrode, wherein
the first semiconductor layer is of a first conductivity type, and
the first electrode is the collector electrode, the silicon carbide semiconductor device further comprising:
a second semiconductor layer of a second conductivity type different from the first conductivity type, which is formed within the semiconductor substrate at the first main surface of the semiconductor substrate;
a third semiconductor layer of the second conductivity type, which is formed on the first semiconductor layer within the semiconductor substrate;
a fourth semiconductor layer of the first conductivity type, which is formed from the first main surface of the semiconductor substrate to an intermediate depth of the third semiconductor layer to surround the second semiconductor layer;
the gate electrode formed on the first main surface via a gate insulating film to cover the fourth semiconductor layer between the second semiconductor layer and the third semiconductor layer;
a second electrode, which is the emitter electrode, formed on the first main surface; and
a second silicide layer positioned between the second semiconductor layer and the second electrode.

7. The silicon carbide semiconductor device according to claim 6, wherein
the second semiconductor layer is made of 4H-SiC, and
the second silicide layer is in contact with the second semiconductor layer and the second electrode.

8. The silicon carbide semiconductor device according to claim 6, wherein
the second semiconductor layer is made of 4H-SiC,
the second silicide layer is in contact with the second electrode, and
a second altered layer made of 3C-SiC is interposed between the second silicide layer and the second semiconductor layer.

9. The silicon carbide semiconductor device according to claim 6, wherein
the semiconductor substrate includes a trench formed from the first main surface toward the second main surface to penetrate the fourth semiconductor layer and reach the third semiconductor layer, and
the gate insulating film and the gate electrode are formed inside the trench.

10. The silicon carbide semiconductor device according to claim 1, further comprising:
a power transistor having a source electrode, a drain electrode, and a gate electrode, wherein the first semiconductor layer is of a first conductivity type, and
the first electrode is the drain electrode, the silicon carbide semiconductor device further comprising:
a second semiconductor layer of the first conductivity type formed within the semiconductor substrate at the first main surface of the semiconductor substrate;
a third semiconductor layer of the first conductivity type formed on the first semiconductor layer within the semiconductor substrate;
a fourth semiconductor layer of a second conductivity type different from the first conductivity type, which is formed from the first main surface of the semiconductor substrate to an intermediate depth of the third semiconductor layer so as to surround the second semiconductor layer; and
the gate electrode formed on the first main surface via a gate insulating film to cover the fourth semiconductor layer between the second semiconductor layer and the third semiconductor layer.

11. The silicon carbide semiconductor device according to claim 1, further comprising:
a diode element having an anode electrode and a cathode electrode, wherein
the first semiconductor layer is of a first conductivity type, and
the first electrode is the cathode electrode, the silicon carbide semiconductor device further comprising:
a second electrode, which is the anode electrode, formed on the first main surface of the semiconductor substrate;
a second semiconductor layer of a second conductivity type different from the first conductivity type, which is formed within the semiconductor substrate at the first main surface; and
a third semiconductor layer of the first conductivity type, which is formed on the first semiconductor layer and has a lower concentration than an impurity concentration of the first semiconductor layer within the semiconductor substrate, wherein
the second semiconductor layer and the third semiconductor layer form a PN junction.

12. The silicon carbide semiconductor device according to claim 1, further comprising:
a diode element having an anode electrode and a cathode electrode, wherein
the first semiconductor layer is of a first conductivity type, and
the first electrode is the cathode electrode, the silicon carbide semiconductor device further comprising:
a second electrode, which is the anode electrode, formed on the first main surface;
a second semiconductor layer of a second conductivity type different from the first conductivity type, which is selectively formed within the semiconductor substrate at the first main surface of the semiconductor substrate;
a third semiconductor layer of the first conductivity type, which is formed on the first semiconductor layer within the semiconductor substrate so as to surround the second semiconductor layer; and
a barrier metal layer covering the second semiconductor layer and the third semiconductor layer and interposed between the second semiconductor layer and the third semiconductor layer and the second electrode, wherein
the second semiconductor layer and the third semiconductor layer form a PN junction.

13. A manufacturing method of a silicon carbide semiconductor device comprising:
a process (a) of preparing a semiconductor substrate made of 4H-SiC and having a first main surface and a second main surface positioned opposite to each other in a thickness direction;
a process (b) of forming a first metal layer on the second main surface of the semiconductor substrate to be in contact with a first semiconductor layer formed within the semiconductor substrate at the second main surface of the semiconductor substrate;
a process (c) of selectively irradiating the first metal layer with a laser beam to form a contact layer including a silicide region and a non-silicide region; and
a process (d) of forming a first electrode in contact with the contact layer, wherein,
in the process (c),
a first silicide layer including the first metal layer is formed in the silicide region irradiated with the laser beam in the first metal layer,
the first metal layer is left in the non-silicide region not irradiated with the laser beam in the first metal layer, and
an altered layer made of 3C-SiC is formed at a boundary between the first semiconductor layer and the first silicide layer in the silicide region.

14. The manufacturing method of a silicon carbide semiconductor device according to claim 13, wherein
the first metal layer includes an aluminum film in contact with the first semiconductor layer and a titanium film positioned on the side of the first metal layer opposite to the first semiconductor layer with respect to the aluminum film, and
in the process (c), the laser beam is emitted from the titanium film side.

15. The manufacturing method of a silicon carbide semiconductor device according to claim 13, wherein
in the process (c),
an area of the non-silicide region not irradiated with the laser beam in a plan view is 10% or more and 60% or less of an area of the second main surface of the semiconductor substrate.
